(19) Europäisches Patentamt
European Patent Office
Office européen des brevets

(11) EP 4 503 120 A1

(12) EUROPEAN PATENT APPLICATION
published in accordance with Art. 153(4) EPC

(43) Date of publication:
**05.02.2025 Bulletin 2025/06**

(21) Application number: **23780595.7**

(22) Date of filing: **28.03.2023**

(51) International Patent Classification (IPC):
***H01L 23/373*** *(2006.01)* ***H01L 23/36*** *(2006.01)*
***H05K 7/20*** *(2006.01)*

(52) Cooperative Patent Classification (CPC):
**H01L 23/36; H01L 23/373; H05K 7/20**

(86) International application number:
**PCT/JP2023/012650**

(87) International publication number:
**WO 2023/190586 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.03.2022 JP 2022054382**

(71) Applicant: **Sekisui Polymatech Co., Ltd.**
**Saitama-city, Saitama 338-0837 (JP)**

(72) Inventors:
- **KUROO, Kenta**
  **Saitama-city, Saitama 338-0837 (JP)**
- **IWAZAKI, Hiromichi**
  **Saitama-city, Saitama 338-0837 (JP)**
- **KUDOH, Hiroki**
  **Saitama-city, Saitama 338-0837 (JP)**

(74) Representative: **Ter Meer Steinmeister & Partner Patentanwälte mbB**
**Nymphenburger Straße 4**
**80335 München (DE)**

(54) **THERMALLY-CONDUCTIVE SHEET**

(57) A heat-conductive sheet including a binder and a heat-conductive filler dispersed in the binder, that is used in a state of being sandwiched between a heating element and a heat-dissipating element, a reflectance of the surface of the heat-conductive sheet in contact with the heating element or the heat-dissipating element being 0.30% or more.



Processed by Luminess, 75001 PARIS (FR)

## Description

### Technical Field

The present invention relates to a heat-conductive sheet.

### Background Art

In electronic devices such as computers, car parts, and mobile phones, heat-dissipating elements such as heat sinks are generally used to dissipate heat generated from heating elements such as semiconductor elements and machine parts. It is known that a heat-conductive sheet is disposed between a heating element and a heat-dissipating element for the purpose of increasing the efficiency of heat transfer to the heat-dissipating element. Heat-conductive sheets are generally used in a compressed state when disposed inside electronic devices, and therefore require high flexibility and further require increased thermal conductivity in order to enhance heat dissipation.
The heat-conductive sheet is required to have a followability to the heating element and the heat-dissipating element in order to further enhance the conduction efficiency. Accordingly, a phase-change-type heat-conductive sheet, a so-called phase change sheet, which is softened or melted by heating, has been studied. For example, PTL 1 discloses a heat-dissipation sheet that at least comprises an alkyl group-introduced silicone oil, an alphaolefin, and heat-conductive filler, wherein the heat-dissipation sheet is putty-like at normal temperature and is softened to be fluidized by heating.
Further, a heat-conductive sheet highly filled with CPAO is also known as a heat-conductive sheet. For example, PTL 2 discloses a heat-curable resin composition containing CPAO and a heat-curable resin, and a molded sheet product thereof.

### Citation List

#### Patent Literatures

PTL1: JP 2004-331835 A
PTL2: JP 2010-185052 A

### Summary of Invention

#### Technical Problem

Meanwhile, in the field of semiconductors, for example, as devices become smaller, semiconductor performance improves, and semiconductors become highly integrated, the density of the heat generated inside the devices is increasing more than ever. Therefore, there is also a need for further efficiency in dissipating the heat generated inside the devices. In response to this need, attempts are being made to improve the efficiency of heat dissipation by heat-conductive sheets, and possible means include, for example, increasing the thermal conductivity, reducing the contact heat resistance, and reducing the actual thickness.
Here, in view of achieving high thermal conductivity in heat-conductive sheets, a technique is employed in which a graphite material having high thermal conductivity is oriented in the thickness direction from the heating element to the heat-dissipating element. Further, in view of reducing contact heat resistance, the surface roughness may be reduced. However, once the surface roughness is reduced to a certain level, it is difficult to further reduce it, and reducing the surface roughness does not necessarily reduce the heat resistance value.
It is therefore an object of the present invention to provide a heat-conductive sheet in which the heat resistance value can be sufficiently reduced in a heat-conductive sheet used between a heat-dissipating element and a heating element.

#### Solution to Problem

As a result of diligent studies, the inventors have found that the aforementioned problems can be solved by a heat-conductive sheet containing a binder and a heat-conductive filler, wherein the reflectance of at least one of the surfaces is 0.30% or more, thereby accomplishing the present invention.
Specifically, the present invention provides [1] to [12] below.

[1] A heat-conductive sheet comprising a binder and a heat-conductive filler dispersed in the binder, that is used in a state of being sandwiched between a heating element and a heat-dissipating element, the heat-conductive sheet having a reflectance of 0.30% or more at a surface in contact with the heating element or the heat-dissipating element.
[2] The heat-conductive sheet according to [1], wherein the heat-conductive sheet has no fluidity in 0 to 100°C.
[3] The heat-conductive sheet according to [1] or [2], wherein the heat-conductive filler comprises an anisotropic filler oriented in a thickness direction of the heat-conductive sheet.
[4] The heat-conductive sheet according to any one of [1] to [3], wherein the heat-conductive filler comprises a graphite material.
[5] The heat-conductive sheet according to any one of [1] to [4], wherein the reflectance is 0.45% or more.
[6] The heat-conductive sheet according to any one of [1] to [5], wherein the binder comprises a crosslinked silicone.
[7] The heat-conductive sheet according to any one of [1] to [6], comprising a phase change material.
[8] The heat-conductive sheet according to [7], wherein a content of the phase change material is 2 to 30 parts by mass per 100 parts by mass of the binder.
[9] The heat-conductive sheet according to [7] or [8], wherein the phase change material is an alkyl silicone.
[10] The heat-conductive sheet according to any one of [1] to [9], wherein the surface with the reflectance of 0.30% or more is a sliced surface.
[11] The heat-conductive sheet according to any one of [1] to [10], wherein an E hardness of the heat-conductive sheet is 10 to 80.
[12] A method for producing the heat-conductive sheet according to any one of [1] to [11], comprising polishing a surface of a molded product comprising a binder and a heat-conductive filler dispersed in the binder.

Advantageous Effect of Invention

The present invention can provide a heat-conductive sheet in which the heat resistance value can be sufficiently reduced.

Brief Description of Drawing

[Fig. 1] Fig. 1 is a schematic view of a heat resistance value measuring machine.

Description of Embodiments

[Heat-conductive sheet]

Hereinafter, a heat-conductive sheet according to an embodiment of the present invention will be described in detail.
The heat-conductive sheet of the present invention is a heat-conductive sheet comprising a binder and a heat-conductive filler dispersed in the binder, that is used in a state of being sandwiched between a heating element and a heat-dissipating element.

<Reflectance>

When the heat-conductive sheet of the present invention is used in a state of being sandwiched between a heating element and a heat-dissipating element, the reflectance of the surface in contact with the heating element or the heat-dissipating element (hereinafter, also simply referred to as "reflectance") is 0.30% or more. When the reflectance is less than 0.30%, the heat resistance value of the heat-conductive sheet increases, the adhesive strength of the heat-conductive sheet to the heat-dissipating element or heating element is impaired, and gaps are generated between the heating element or heat-dissipating element and the heat-conductive sheet, which prevents the heat-conductive sheet from sufficiently demonstrating thermal conductivity.
**In** the present invention, of the surfaces of the heat-conductive sheet, at least one of the surface in contact with the heating element and the surface in contact with the heat-dissipating element may have a reflectance of 0.30% or more, but it is preferable that both surfaces have a reflectance of 0.30% or more. When both surfaces have a reflectance of 0.30% or more, the heat-conductive sheet can be adhered to both heat-dissipating element and heating element, and its heat resistance value can be even further reduced.
**In** the present invention, in view of enhancing adhesion and more effectively reducing the heat resistance value, the reflectance is preferably 0.45% or more, more preferably 0.50% or more, further preferably 0.55% or more. Although it is not clear how a higher reflectance improves thermal conductivity, it is not simply due to an increase in the smoothness of the surfaces of the heat-conductive sheet. Rather, it is presumed that a plurality of factors, such as a change in the ratio of

resin and heat-conductive filler due to their different polishability, an increase in the anisotropic filler disposed so as to fall on the surface, or the polishing of the side surface (side of the major axis) of the anisotropic filler that is disposed so as to fall on the surface, increase the adhesive strength to the heating element or heat-dissipating element, and thereby reduce the heat resistance value.

Further, the upper limit of the reflectance is not specifically limited, but is practically, for example, 4.0% or less, preferably 3.5% or less, more preferably 2.0% or less.

The reflectance can be obtained by the measurement method described in the Examples described later.

<Fluidity>

The heat-conductive sheet of the present invention preferably has no fluidity in 0 to 100°C. Here, no fluidity means that the components constituting the heat-conductive sheet do not flow out of the heat-conductive sheet when it is heated from 0°C to 100°C. The heat-conductive sheet should be able to retain its shape even when heated to 100°C. **In** this case, the heat-conductive sheet may slightly change shape when heated, but this essentially remains an elastic deformation, and the heat-conductive sheet can return to its original shape after being cooled. When the heat-conductive sheet has such properties, the shape of the heat-conductive sheet can be substantially retained without the components of the heat-conductive sheet flowing out due to the heat generated by the heating element when the heat-conductive sheet is used in a state of being sandwiched between a heat-dissipating element and a heating element. Thus, good thermal conductivity can be exhibited.

When the heat-conductive sheet contains a phase change material, as will be described below, the shape of the heat-conductive sheet should be retained even when the heat-conductive sheet is heated to a temperature higher than the melting point of the phase change material. In other words, the phase change material itself may melt, but the melted phase change material should not flow out.

<Binder>

The binder used in the heat-conductive sheet of the present invention is a polymer compound such as elastomer, rubber, or the like, and is preferably a product formed by curing a liquid polymer composition (curable polymer composition) composed of a mixture system such as a base resin and a curing agent. For example, the curable polymer composition may be composed of uncrosslinked rubber and a crosslinking agent, or may contain a monomer, prepolymer, or the like, and a curing agent. The above curing reaction may be normal temperature curing or heat curing. The binder formed from the curable polymer composition is preferably a crosslinked matrix with a crosslinked structure. Further, examples of the binder preferably include a silicone matrix.

(Silicone matrix)

The silicone matrix is preferably silicone having no fluidity at any of room temperature (23°C) and high temperature (80°C). Since the silicone matrix has no fluidity, the shape retention of the heat-conductive sheet can be ensured at normal temperature and high temperature.

For example, silicone rubber may be used as the silicone matrix in the present invention. Use of silicone rubber facilitates compressive deformation so that the heat-conductive sheet can be installed easily between a heating element and a heat-dissipating element. Further, use of silicone rubber can impart a certain compression characteristic to the heat-conductive sheet, so that the reliability can be enhanced.

The silicone to be used for the silicone matrix may be any of the condensation reaction type and the addition reaction type, and is preferably the addition reaction type because of the following reasons: a large amount of the heat-conductive filler is easily filled therein, and the curing temperature can be easily adjusted by a catalyst or the like. The silicone matrix can be obtained, for example, by curing a curable silicone composition. The curable silicone composition may be formed, for example, of a base resin and a curing agent.

In the case where the curable silicone composition is of the addition reaction type, it preferably contains an alkenyl group-containing organopolysiloxane as a base resin and hydrogen organopolysiloxane as a curing agent, in view of ease of filling a large amount of the heat-conductive filler.

The curable silicone composition is preferably in a liquid form before cured. In the case where the curable silicone composition is in a liquid form before cured, a large amount of the heat-conductive filler can be easily filled therein. Herein, a liquid form means a liquid at normal temperature (23°C) and under 1 atm.

Further, it is preferable to use a crosslinked silicone, more preferable to use a three-dimensionally crosslinked silicone matrix as the silicone matrix, in view of ensuring the shape retention of the heat-conductive sheet. In the case of, for example, an addition reaction type, this purpose may be achieved by curing a curable silicone composition containing: an alkenyl group-containing organopolysiloxane having at least three or more alkenyl groups in one molecule; or a hydrogen

organopolysiloxane having at least three or more hydrogen atoms added to a silicon atoms.

The content of the silicone matrix may be, for example, about 5 to 50 mass%, preferably 8 to 35 mass%, more preferably 12 to 25 mass%, with respect to the total amount of the heat-conductive sheet.

(Phase change material)

In the heat-conductive sheet, the binder component preferably contains a phase change material. When the heat-conductive sheet contains a phase change material, the flexibility can be increased when heating, and the adhesion to the heating element or heat-dissipating element is significantly more easily increased. It also makes it easier to improve the reflectance of the surfaces of the heat-conductive sheet.

A heat-conductive sheet with increased adhesive strength is beneficial in the following applications. For example, since substrates are thin in miniaturized and highly integrated semiconductors, the thinner the substrate becomes, the more likely warping of the substrate due to heat generation is to occur. On the other hand, since heat-conductive sheets generally have rebound resilience, they can easily absorb changes in thickness by having a certain degree of thickness, and have been suitably used without gaps even when warping of the substrate occurred. However, when the heat-conductive sheet has its thickness reduced as described above, it less readily absorbs changes in thickness when used in a compressed state. Therefore, it has become necessary to increase the adhesion to the heat-dissipating element or heating element so that the space between the heat-dissipating element and heating element can be filled without gaps even when warping of the substrate or the like occurs.

The phase change material is a material that changes from solid to liquid upon heating. The phase change material may be a compound that is liquid at room temperature (23°C) or a compound that is capable of being melted by heating at a certain temperature (for example, a temperature over 23°C and 80°C or less), but in view of easily increasing flexibility when heated, it is preferably in a solid form at room temperature and under 1 atm. Accordingly, the melting point of the phase change material is preferably higher than normal temperature (23°C), more preferably 30°C or more, further preferably 35°C or more.

The melting point of the phase change material is preferably 80°C or less, more preferably 70°C or less, further preferably 60°C or less, even more preferably 50°C or less, in view of melting the material by heating at high temperature (for example, 80°C).

The melting point of the phase change material is the temperature of the endothermic peak in the DTA curve measured using thermogravimetric differential thermal analysis (TGDTA) at a heating rate of 1°C/min. Further, in the case where the alkyl silicone is a mixture of the phase change material, the melting point is the maximum endothermic peak in the aforementioned temperature range.

Specific examples of the phase change material include liquid paraffin, paraffin waxes, vaseline, polyalphaolefin (PAO), alkyl silicone, polyethylene waxes, and polypropylene waxes. Vaseline is a semi-solid hydrocarbon compound, which is a mixture of a plurality of hydrocarbon compounds including isoparaffin, cycloparaffin, and naphthene. Examples of vaseline can also include white vaseline defined in the Japanese Pharmacopoeia.

Among these, paraffin waxes, vaseline, polyalphaolefin (PAO), alkyl silicones, polyethylene waxes, and polypropylene waxes are preferable, and polyalphaolefin (PAO) and alkyl silicones are more preferable, in view of effectively increasing the reflectance of the surfaces of the heat-conductive sheet.

When using polyalphaolefin (PAO) as a phase change material, crystalline polyalphaolefin (CPAO) having crystallinity is more preferable. Polyalphaolefin is a polymer of alpha-olefins. The type of the alpha-olefins is not particularly limited, and they may have a linear or branched chain, or a cyclic structure. Polyalphaolefin is, for example, a polymer of alpha-olefins having 2 to 30 carbon atoms, preferably having 6 to 20 carbon atoms. The number of carbon atoms of alpha-olefins may be increased, for example, so that the crystalline polyalphaolefin may be a side-chain crystalline polyalphaolefin.

Polyalphaolefin may be a polymer of single alpha-olefins or may be a copolymer of two or more alpha-olefins.

Examples of the alkyl silicone include compounds having a polysiloxane backbone on the main chain and an alkyl group. The alkyl group is an alkyl group bound to a silicon atom, and preferably includes alkyl groups having 8 or more carbon atoms. Among these, as the alkyl silicone, an alkyl silicone represented by the following formula (1) is preferable.

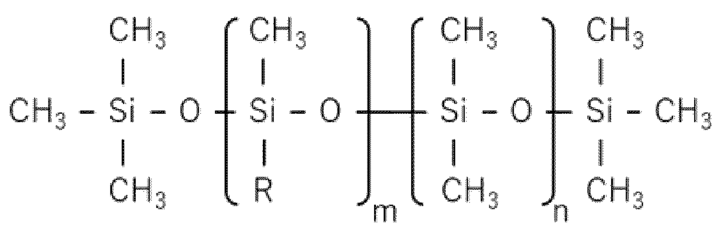

(1)

Here, R indicates an alkyl group having 8 or more carbon atoms, and m and n are integers where m:n is in the range of 100:0 to 50:50. Further, the sum of m and n is 20 or more and 1000 or less.

The alkyl group having 8 or more carbon atoms may be a straight-chain alkyl group or a branched chain alkyl group, but it is preferably a straight-chain alkyl group.

Here, the number of carbon atoms of the alkyl group is preferably in the range of 8 to 26, and more preferably in the range of 12 to 22. When R is an alkyl group having 8 or more carbon atoms, the melting point of the alkyl silicone can be prevented from being too low. On the other hand, when R is an alkyl group having 26 or less carbon atoms, an alkyl silicone with a melting point of 80°C or less is more easily obtained.

R is not specifically limited, but is preferably a dodecyl group, a tetradecyl group, a pentadecyl group, a hexadecyl group, a heptadecyl group, an octadecyl group, a nonadecyl group, an icosyl group, a henicosyl group, a docosyl group, and the like, and more preferably an octadecyl group.

Further, when m:n is 100:0, the properties of the alkyl silicone become similar to those of so-called hard resins at temperatures equal to or below its melting point, and when m:n gets closer to 50:50, it becomes to have more wax-like properties. In other words, using an appropriate amount of alkyl silicone with an m:n of 100:0 allows to make the heat-conductive sheet harder to a certain degree and to improve the handleability.

The alkyl silicone is particularly preferably polyoctadecylmethylsiloxane (R = 18, m:n = 100:0).

The alkyl silicone may be an alkyl silicone other than the compound represented by the formula (1) described above, and may be, for example, an alkyl silicone having a substituent other than an alkyl group.

Using the above substances as the polyalphaolefin (PAO) and alkyl silicone allows to more effectively increase the reflectance of the surfaces of the heat-conductive sheet.

A single type of the phase change material may be contained alone, or two or more types of them may be contained in combination.

The content of the phase change material is preferably 1 to 45 parts by mass, more preferably 2 to 30 parts by mass, further preferably 5 to 20 parts by mass, with respect to 100 parts by mass of the binder. When the content of the phase change material is the aforementioned lower limit or more, the reflectance of the surfaces of the heat-conductive sheet can be effectively improved. Further, when the content of the phase change material is the aforementioned upper limit or less, the content ratio of the binder component can be a certain level or more and the adhesive strength of the heat-conductive sheet can be increased, which allows to also effectively improve the reflectance.

<Heat-conductive filler>

In the heat-conductive sheet of the present invention, a heat-conductive filler is preferably dispersed in the binder to be held by the binder.

The heat-conductive filler may be an anisotropic filler or a non-anisotropic filler, or both of them may be used in combination. The heat-conductive filler preferably includes at least an anisotropic filler, more preferably includes both of an anisotropic filler and a non-anisotropic filler. The heat-conductive sheet tends to enhance the thermal conductivity when containing an anisotropic filler.

The anisotropic filler is preferably oriented in one direction, and specifically, preferably oriented in the thickness direction of the heat-conductive sheet. When the anisotropic filler is oriented in the thickness direction, the thermal conductivity in the thickness direction tends to be enhanced.

When the anisotropic filler is oriented in the thickness direction, the long-axis direction is not necessarily strictly parallel to the thickness direction, and the long-axis direction inclined to some extent in the thickness direction is also considered to be oriented in the thickness direction. Specifically, those with the long-axis direction inclined at about less than 20° are also considered to be an anisotropic filler oriented in the thickness direction, and when such anisotropic filler are predominant (for example, over 60%, preferably over 80%, with respect to the total number of particles of the anisotropic filler) in the heat-conductive sheet, they are considered to be oriented in the thickness direction.

Further, in the above description, the anisotropic filler has been explained on the premise that they are oriented in the thickness direction; however, the same applies to the case where they are oriented in another direction.

The heat-conductive sheet preferably contains a graphite material. The thermal conductivity tends to be further enhanced when a graphite material is contained. The reflectance generally tends to be lower when a graphite material is contained than when a graphite material is not contained. However, in the present invention, even in a heat-conductive sheet containing a graphite material, the adhesive strength and thermal conductivity is easily enhanced by having a reflectance of a certain value or more as described above. The graphite material may be an anisotropic filler or a non-anisotropic material, but it is preferably an anisotropic filler.

The content of the heat-conductive filler is preferably 150 to 3000 parts by mass, more preferably 200 to 2000 parts by mass, further preferably 300 to 1000 parts by mass, with respect to 100 parts by mass of the binder. When the content of the heat-conductive filler is 150 parts by mass or more, a certain thermal conductivity can be imparted to the heat-conductive sheet. Further, when it is 3000 parts by mass or less, the reflectance of the heat-conductive sheet can be a

certain level or more. The ratio of the binder in the heat-conductive sheet can also be a certain level or more, which increases the adhesive strength of the heat-conductive sheet and allows to reduce the heat resistance value.

(Anisotropic filler)

The anisotropic filler is a filler that has an anisotropic shape and is capable of being oriented. Examples of the anisotropic filler include fiber materials and flaky materials. The anisotropic filler has a high aspect ratio, specifically, an aspect ratio of over 2, and preferably has an aspect ratio of 5 or more. An anisotropic filler having the aspect ratio over 2 easily orients in one direction, for example, the thickness direction, and thus the thermal conductivity in the one direction, for example, the thickness direction of the heat-conductive sheet is easily enhanced. Further, the upper limit of the aspect ratio is not specifically limited, but is practically 100.

The aspect ratio is the ratio of the length in the long-axis direction to the length in the short-axis direction of the anisotropic filler. The aspect ratio means the fiber length/the fiber diameter when it is a fiber material, and means the length in the long-axis direction of a flake/the thickness thereof when it is a flaky material.

The content of the anisotropic filler in the heat-conductive sheet is preferably 10 to 500 parts by mass, more preferably 30 to 300 parts by mass, further preferably 50 to 250 parts by mass, with respect to 100 parts by mass of the binder.

When the content of the anisotropic filler is 10 parts by mass or more, the thermal conductivity is easily enhanced. Further, when it is 500 parts by mass or less, the viscosity of the mixed composition, which will be described below, tends to be appropriate, and the orientation of the anisotropic filler is enhanced. Further, the dispersibility of the anisotropic filler in the binder is also enhanced.

In the case where the anisotropic filler is a fiber material, the average fiber length is preferably 10 to 500 μm, more preferably 20 to 350 μm, further preferably 50 to 300 μm. Fibers of an anisotropic filler having an average fiber length of 10 μm or more are appropriately in contact with each other inside the heat-conductive sheet, to ensure a heat transfer path, so that the thermal conductivity of the heat-conductive sheet is enhanced.

On the other hand, when the anisotropic filler has an average fiber length of 500 μm or less, the bulk of the anisotropic filler is low, so that a large amount thereof can be filled in the binder component.

The average fiber length of fiber materials is preferably shorter than the thickness of the heat-conductive sheet. The average fiber length shorter than the thickness prevents the fiber materials from protruding from the surface of the heat-conductive sheet more than necessary.

The average fiber length can be calculated through observing the anisotropic filler with a microscope. More specifically, the fiber lengths of any 50 fibers of the anisotropic filler are measured, for example, using an electron microscope or optical microscope, and the average (arithmetic mean) thereof can be taken as an average fiber length.

In the case where the anisotropic filler is a flaky material, the average particle size is preferably 10 to 400 μm, more preferably 15 to 300 μm, further preferably 20 to 200 μm. Flakes of the anisotropic filler having an average particle size of 10 μm or more are easily in contact with each other in the heat-conductive sheet, to surely create a heat transfer path, so that the thermal conductivity of the heat-conductive sheet is enhanced. When the anisotropic filler has an average particle size of 400 μm or less, the bulk of the heat-conductive sheet to be low, so that a large amount of the anisotropic filler can be filled in the binder component.

The average particle size of the flaky material can be calculated by observing the anisotropic filler with a microscope and determining the major diameter as a diameter. More specifically, the major diameters of any 50 flakes of anisotropic filler are measured, for example, using an electron microscope or optical microscope, and the average (arithmetic mean) thereof can be taken as an average particle size.

As the anisotropic filler, any known material having a thermal conductivity may be used. The anisotropic filler is preferably diamagnetic in the case where it is to be oriented by the magnetic field orientation, as will be described below. The anisotropic filler may not be diamagnetic in the case where it is to be oriented by fluidized orientation or not oriented.

Specific examples of the anisotropic filler include carbon materials typified by carbon fibers and flaky carbon powder, metal materials typified by metal fibers, and metal oxides, boron nitride, metal nitride, metal carbide, metal hydroxide, and polyparaphenylene benzoxazole fibers. Among these, carbon materials are preferable in view of having a small specific gravity and a good dispersibility in the binder component. Among them, graphite materials having a high thermal conductivity are more preferable. A graphite material is diamagnetic when the graphite planes are aligned in a predetermined direction.

Boron nitride is also preferable as the anisotropic filler. Boron nitride is preferably used in the form of a flaky material, but is not limited thereto. The flaky boron nitride may be agglomerated or may not be agglomerated, but the flaky boron nitride is preferably partially or fully not agglomerated. The boron nitride or the like is also diamagnetic when the crystal planes are aligned in a predetermined direction.

The anisotropic filler generally have a thermal conductivity in the anisotropic direction (that is, long-axis direction) of 30 W/m·K or more, preferably 60 W/m·K or more, more preferably 100 W/m·K or more, further preferably 200 W/m·K or

more, without specific limitation. The upper limit of the thermal conductivity of the anisotropic filler is not specifically limited, but is, for example, 2000 W/m·K or less. The thermal conductivity can be measured by the laser flash method or the like.

A single type of the anisotropic filler may be used alone, or two or more types of them may be used in combination. For example, at least two anisotropic fillers having different average particle sizes or average fiber lengths may be used as the anisotropic filler. It is considered that, when the anisotropic fillers having different sizes are used, particles of the small anisotropic filler enter between particles of the relatively large anisotropic filler, so that the binder component can be filled with the anisotropic fillers at a high density, and the heat conduction efficiency can thus be enhanced.

The carbon fiber used as the anisotropic filler is preferably a graphitized carbon fiber. Flaky graphite powder is preferable as flaky carbon powder. It is also preferable to use the graphitized carbon fiber and the flaky graphite powder in combination as the anisotropic filler.

The graphitized carbon fiber has graphite crystal planes aligned in the fiber axis direction and thus has high thermal conductivity in the fiber axis direction. Therefore, the thermal conductivity in a specific direction can be enhanced by aligning the fiber axis directions in a predetermined direction. The flaky graphite powder has graphite crystal planes aligned in the plane direction of the flake surface and thus has high thermal conductivity in the plane direction. Therefore, the thermal conductivity in a specific direction can be enhanced by aligning the flake surfaces in a predetermined direction. The graphitized carbon fiber and flaky graphite powder each preferably have a high degree of graphitization.

Further, when flaky graphite powder is added, the flake surface of the flaky graphite powder near the surface is polished along the polished surface in the polishing step. As a result, the heat resistance can be reduced and the reflectance increased.

As the graphite materials such as graphitized carbon fibers and flaky graphite powder described above, graphitized products of the following raw materials can be used. Examples of the raw materials include condensed polycyclic hydrocarbon compounds such as naphthalene, PAN (polyacrylonitrile), and condensed heterocyclic compounds such as pitch. **In** particular, graphitized mesophase pitch, polyimide, or polybenzazole having a high degree of graphitization is preferably used. For example, when mesophase pitch is used, the pitch is oriented in the fiber axis direction due to its anisotropy in the spinning step, which will be described below, to give graphitized carbon fibers having excellent thermal conductivity in the fiber axis direction.

The form of the mesophase pitch used for the graphitized carbon fiber is not specifically limited, as long as it can be spun, and the mesophase pitch may be used alone or in combination with another raw material. However, use of the mesophase pitch alone, or in other words, a graphitized carbon fiber with a mesophase pitch content of 100% is most preferable in view of high thermal conductivity, spinnability, and quality stability.

The graphitized carbon fibers to be used may be those obtained by sequentially performing spinning, infusibilization, and carbonization, pulverizing or cutting into a predetermined particle size, and then graphitizing, or those obtained by carbonizing, pulverizing or cutting, and then graphitizing. In the case where pulverizing or cutting is performed before graphitization, a graphitized carbon fiber with a further improved thermal conductivity can be obtained, since polycondensation reaction and cyclization reaction are likely to proceed during graphitization on the surface newly exposed by pulverization, to enhance the degree of graphitization. In the case where the spun carbon fiber is pulverized after graphitization, the carbon fiber after graphitization is rigid and thus easy to pulverize, and carbon fiber powder having a relatively narrow fiber length distribution can be obtained by pulverization in a short time.

The average fiber length of the graphitized carbon fiber is preferably 10 to 500 $\mu$m, more preferably 20 to 350 $\mu$m, further preferably 50 to 300 $\mu$m, as mentioned above. The aspect ratio of each graphitized carbon fiber is over 2, preferably 5 or more, as mentioned above. The thermal conductivity of the graphitized carbon fiber is not specifically limited, but the thermal conductivity in the fiber axis direction is preferably 400 W/m·K or more, more preferably 800 W/m·K or more.

In the case where the heat-conductive sheet contains the anisotropic filler, the anisotropic filler may be exposed or may not be exposed on the sheet surface, but are preferably exposed. The sheet surface of the heat-conductive sheet can be a non-adhesive surface due to exposure of the anisotropic filler. The heat-conductive sheet serves as the main surface of the sheet, and the anisotropic filler may be exposed on any one of both faces of the sheet or may be exposed on both faces. In the case where the heat-conductive sheet has a non-adhesive sheet surface, it can be slid when it is installed into an electronic device or the like, improving the installability.

(Non-anisotropic filler)

The non-anisotropic filler is a material that imparts thermal conductivity to the heat-conductive sheet when used alone or together with the anisotropic filler. Particularly, when used in combination with the anisotropic filler oriented in one direction, the non-anisotropic filler can intervene in the gap between particles of the oriented anisotropic filler, to further increase the thermal conductivity. The non-anisotropic filler is a filler that has substantially no anisotropy in shape and is not oriented in a predetermined direction even under an environment in which anisotropic filler is oriented in a predetermined direction, such as under the generation of magnetic force lines or the action of shear force, which will be described below.

The non-anisotropic filler has an aspect ratio of 2 or less, preferably 1.5 or less. When used in combination with

the anisotropic filler, the non-anisotropic filler having such a low aspect ratio is likely to be positioned in the gaps between the anisotropic filler and thus tends to improve the thermal conductivity. Further, the non-anisotropic filler having an aspect ratio of 2 or less can prevent increase of the viscosity of the mixed composition, which will be described below, to achieve high filling rate.

Specific examples of the non-anisotropic filler include metals, metal oxides, metal nitrides, metal hydroxides, carbon materials, and oxides, nitrides, and carbides of others than metals. Examples of the shape of the non-anisotropic filler include spherical or amorphous powder.

For the non-anisotropic filler, examples of the metals include aluminum, copper, and nickel; examples of the metal oxides include aluminum oxide typified by alumina, magnesium oxide, and zinc oxide; and examples of the metal nitrides include aluminum nitride. Examples of the metal hydroxides include aluminum hydroxide. Examples of the carbon materials include spherical graphite. Examples of the oxides, nitrides, and carbides of others than metals include quartz, boron nitride, and silicon carbide.

Among these, aluminum oxide and aluminum are preferable, in view of their high thermal conductivity and availability of spherical materials, and aluminum is more preferable.

The non-anisotropic fillers described above may be used singly or in combination of two or more.

The average particle size of the non-anisotropic filler is, for example, 0.1 to 200 μm. For example, when used in combination with the anisotropic filler, the average particle size of the non-anisotropic filler is preferably 0.1 to 50 μm, more preferably 0.5 to 35 μm, further preferably 1 to 15 μm. When the average particle size is 50 μm or less, defects such as disturbing the orientation of the anisotropic filler are less likely to occur, even when used in combination with the anisotropic filler. When the average particle size is 0.1 μm or more, the non-anisotropic filler has a specific surface area not increased more than necessary, and even when such a non-anisotropic filler is contained in a large amount, the viscosity of the mixed composition is difficult to increase so that a large amount of the non-anisotropic filler is easily filled.

As the non-anisotropic filler, at least two non-anisotropic fillers having different average particle sizes may be used, for example.

When using the non-anisotropic filler(s) singly as the heat-conductive filler, the average particle size is preferably 0.1 to 200 μm, more preferably 0.5 to 100 μm, further preferably 1 to 70 μm. In this case, two or more non-anisotropic fillers having different average particle sizes are preferably used in combination, and a small-particle size heat-conductive filler having average particle size of 0.1 μm or more and 5 μm or less and a large-particle size heat-conductive filler having an average particle size of over 5 μm and 200 μm or less are preferably used in combination, in view of enhancing the thermal conductivity of the heat-conductive sheet. When using the small-particle size heat-conductive filler and the large-particle size heat-conductive filler in combination, their mass ratio (large-particle size heat-conductive filler/small-particle size heat-conductive filler) is preferably 0.1 to 10, more preferably 0.3 to 7, further preferably 1 to 5.

The average particle size of the non-anisotropic filler can be measured through observation with an electron microscope or the like. More specifically, the particle sizes of any 50 particles of the non-anisotropic filler are measured, for example, using an electron microscope or optical microscope, and the average (arithmetic mean) thereof can be taken as an average particle size.

The content of the non-anisotropic filler is preferably 50 to 2500 parts by mass, more preferably 100 to 1500 parts by mass, further preferably 200 to 750 parts by mass, with respect to 100 parts by mass of the binder. When it is 50 parts by mass or more, the thermal conductivity of the heat-conductive sheet can be enhanced. When it is 1500 parts by mass or less, the non-anisotropic filler is appropriately dispersed in the binder component, and the effect of enhancing the thermal conductivity according to the content can be obtained. Also, the viscosity of the mixed composition can be prevented from increasing more than necessary.

(Additives)

The heat-conductive sheet of the present invention may further contain various additives, as long as the functions of the heat-conductive sheet are not impaired. Examples of the additives include at least one or more selected from dispersants, coupling agents, pressure-sensitive adhesives, flame retardants, antioxidants, colorants, and anti-settling agents. When curing a polymer composition such as a curable silicone composition as will be described below, a curing catalyst or the like to accelerate curing may be contained as an additive. In the case of a curable silicone composition, examples of the curing catalyst include a platinum catalyst.

The mixed composition may contain a compatible substance, as will be described below. The compatible substance may volatilize in the process of producing the heat-conductive sheet so as not to remain, or the compatible substance contained may at least partially remain, in the heat-conductive sheet.

[Properties and other characteristics of heat-conductive sheet]

In the heat-conductive sheet, the surface with a reflectance of 0.30% or more is preferably a sliced surface. In

other words, in the present invention, the surface of the heat-conductive sheet in contact with the heat-dissipating element or the heating element is preferably a sliced surface. When such a surface is a sliced surface, the reflectance can be effectively increased. In the heat-conductive sheet, one of the surfaces may be a sliced surface, or both surfaces may be sliced surfaces.

A sliced surface is the surface formed by cutting with a shearing blade or a laser, as will be described below. The sliced surface may undergo further surface treatments such as polishing after being cut.

(Adhesive strength)

The heat-conductive sheet of the present invention has an adhesive strength of preferably 0.1 MPa or more, more preferably 0.45 MPa or more, further preferably 1.0 MPa or more. When the adhesive strength is the aforementioned lower limit or more, the adhesion of the heat-conductive sheet to the heating element or heat-dissipating element becomes sufficient, and gaps between the heating element or heat-dissipating element are less likely to occur, which allows to obtain excellent thermal conductivity. Further, the upper limit of the adhesive strength is not specifically limited, but in view of allowing to more easily correct the position of the heat-conductive sheet once it has been disposed between the heating element and the heat-dissipating element, it is preferably 8 MPa or less, more preferably 5 MPa or less, further preferably 3 MPa or less.

The adhesive strength can be obtained by the measurement method described in the Examples.

(Heat resistance value)

The heat-conductive sheet of the present invention has a heat resistance value of preferably 0.18°C/W or less, more preferably 0.14°C/W or less, further preferably 0.106°C/W or less. When the heat resistance value is the aforementioned upper limit or less, the efficiency of heat transfer from the heating element to the heat-dissipating element via the heat-conductive sheet is improved, which allows to obtain excellent thermal conductivity. In the present invention, the heat resistance value is preferably as low as possible and may be 0°C/W or more, but it is practically, for example, 0.01°C/W or more, preferably 0.05°C/W or more.

The heat resistance value can be obtained by the measurement method described in the Examples.

(E hardness)

The heat-conductive sheet of the present invention has a type E hardness as defined in JIS K6253 (hereinafter also referred to as "E hardness") of preferably 10 to 80, more preferably 20 to 70, further preferably 30 to 65. When the E hardness is the aforementioned lower limit or more, it is easier to polish the heat-conductive sheet in the step (B) described later, and easier to obtain a reflectance of 0.30% or more for the surfaces of the heat-conductive sheet. Further, when the E hardness is the aforementioned upper limit or less, a certain flexibility is imparted to the heat-conductive sheet, and the adhesive strength of the heat-conductive sheet is more easily increased.

(Thickness)

The thickness of the heat-conductive sheet of the present invention is not specifically limited, and the thickness may be appropriately set according to the shape or application of the electronic device in which the heat-conductive sheet is installed, and the thickness is preferably 0.05 to 5 mm, more preferably 0.1 to 3 mm, further preferably 0.15 to 2 mm.

[Method for producing heat-conductive sheet]

The heat-conductive sheet of the present invention can be produced by a method including step (A) and step (B) below.

Step (A): obtaining a molded product containing a binder and a heat-conductive filler dispersed in the binder
Step (B): polishing the surface of the molded product

Hereinafter, each step will be described in further detail.

<Step (A)>

In step (A), it is preferable to obtain an oriented molded product in which an anisotropic filler is oriented along one direction, which is the thickness direction in the heat-conductive sheet, and then cutting the oriented molded product into a

sheet to obtain a sheet-form molded product. Then, it is preferable to polish the sheet-form molded product in step (B).

Further, the molded product may be obtained by mixing at least a polymer composition, a phase change material, and a heat-conductive filler to obtain a mixed composition and then curing the mixed composition, but the mixed composition is preferably further mixed with a compatible substance.

Hereinafter, preferred embodiments of step (A) will be described in detail.

As mentioned above, the mixed composition for obtaining the molded product is preferably obtained by mixing a polymer composition, a phase change material, a heat-conductive filler, and a compatible substance. The compatible substance is a substance that is dissolved in the phase change material and is compatible with a polymer composition such as a curable silicone composition. The phase change material may have a lower compatibility with polymer compositions such as a curable silicone composition, but can be uniformly mixed with a polymer composition by using a compatible substance. Therefore, the compatible substance is uniformly mixed in a binder such as a silicone matrix, which is to be obtained by curing a polymer composition.

As for the mixing method of the aforementioned components, as long as a mixed composition can be obtained by mixing the aforementioned components, the mixing method and the mixing order are not specifically limited. The polymer composition, the phase change material, the heat-conductive filler, the compatible substance, and any other components to be added as required may be appropriately mixed in any order, to obtain a mixed composition.

However, the phase change material is preferably dissolved in the compatible substance before being mixed with the polymer composition (more specifically, the base resin, curing agent, and the like constituting the polymer composition) and other components.

In this case, a mixture of the phase change material and the compatible substance, the polymer composition (or the base resin and the curing agent), the heat-conductive filler, and any other components added as required may be mixed in any order, to obtain a mixed composition.

When the phase change material is dissolved in the compatible substance in step (A) in this way, the phase change material can be mixed in the binder more uniformly.

In the case where the phase change material is dissolved in the compatible substance, they may be appropriately heated. The heating temperature is preferably higher than the melting point of the phase change material and may be, for example, 40°C or more for dissolution. In the case where the compatible substance is mixed in the base resin and the curing agent, the upper limit of the heating temperature may be a temperature at which the polymer composition does not substantially cure in the process of mixing.

(Compatible substance)

The compatible substance is preferably a substance that is dissolved in the phase change material and is compatible with a polymer composition such as a curable silicone composition. The compatible substance is preferably a component that volatilizes by heating at the time of curing or the like.

The compatible substance to be used is preferably an alkoxysilane compound. **In** the case where the alkoxysilane compound is used, the appearance is improved, and specifically, air voids or the like are not seen in the surface of the heat-conductive sheet obtained by curing.

The alkoxysilane compound to be used as the compatible substance is a compound having a structure in which, among the 4 bonds from a silicon atom (Si), 1 to 3 bonds each attach to an alkoxy group, and the residual bonds each attach to an organic substituent.

Examples of the alkoxy group of the alkoxysilane compound include methoxy groups, ethoxy groups, protoxy groups, butoxy groups, pentoxy groups, and hexatoxy groups. In the polymer composition, the alkoxysilane compound may be contained in the form of a dimer.

Among such alkoxysilane compounds, an alkoxysilane compound having at least either one of a methoxy group and an ethoxy group is preferable, in view of the availability. The number of alkoxy groups in the alkoxysilane compound is preferably 2 or 3, more preferably 3, in view of the compatibility, the solubility, and the like, with the polymer composition. Specifically, the alkoxysilane compound is preferably at least one selected from trimethoxysilane compounds, triethoxysilane compounds, dimethoxysilane compounds, and diethoxysilane compounds.

Examples of the functional group contained in the organic substituent of the alkoxysilane compound include an acryloyl group, an alkyl group, a carboxyl group, a vinyl group, a methacryl group, an aromatic group, an amino group, an isocyanate group, an isocyanurate group, an epoxy group, a hydroxyl groups, and a mercapto group. Here, when using a platinum catalyst as a curing catalyst of the polymer composition, an alkoxysilane compound that is difficult to affect the curing reaction of organopolysiloxane is preferably selected and used. Specifically, when using an addition reaction type organopolysiloxane with a platinum catalyst, the organic substituent of the alkoxysilane compound is preferably free from an amino group, an isocyanate group, an isocyanurate group, a hydroxyl group, or a mercapto group.

The alkoxysilane compound preferably contains an alkylalkoxysilane compound having an alkyl group bound to a silicon atom, that is, an alkoxysilane compound having an alkyl group as an organic substituent. Accordingly, a dialkyl

dialkoxysilane compound and an alkyltrialkoxysilane compound are preferable, and among them, an alkyltrialkoxysilane compound is preferable.

The number of carbon atoms of the alkyl group bound to the silicon atom may be, for example, 1 to 16. In the trialkoxysilane compound such as trimethoxysilane compounds and triethoxysilane compounds, the number of carbon atoms of the alkyl group is preferably 6 or more, further preferably 8 or more, and preferably 12 or less, more preferably 10 or less.

In the dialkoxysilane compound such as dimethoxysilane compounds and triethoxysilane compounds, the number of carbon atoms of the alkyl group may be 1 or more, and is preferably 10 or less, more preferably 6 or less, further preferably 4 or less.

Examples of the alkyl group-containing alkoxysilane compound include methyltrimethoxysilane, dimethyldimethoxysilane, diethyldimethoxysilane, trimethylmethoxysilane, methyltriethoxysilane, dimethyldiethoxysilane, ethyltrimethoxysilane, n-propyltrimethoxysilane, di-n-propyldimethoxysilane, di-n-propyldiethoxysilane, isobutyltrimethoxysilane, isobutyltriethoxysilane, isobutyltrimethoxysilane, isobutyltriethoxysilane, n-hexyltrimethoxysilane, n-hexyltriethoxysilane, methylcyclohexyldimethoxysilane, methylcyclohexyldiethoxysilane, n-octyltrimethoxysilane, n-octyltriethoxysilane, n-decyltrimethoxysilane, and n-decyltriethoxysilane.

Among the alkyl group-containing alkoxysilane compounds, n-decyltrimethoxysilane, dimethyldimethoxysilane, and n-octyltriethoxysilane are further preferable, and n-decyltrimethoxysilane and n-octyltriethoxysilane are furthermore preferable.

An alkoxysiloxane compound used as the compatible substance has two or more siloxane bonds, and has a structure in which at least one silicon atom has an alkoxy group. The alkoxysiloxane compound has a structure in which at least one of the silicon atoms constituting the siloxane bond has an organic substituent.

Examples of the alkoxy group and the organic substituent of the alkoxysiloxane compound include those described above for the alkoxysilane compound, and the alkoxysiloxane compound preferably has at least an alkyl group.

Examples of the alkoxysiloxane compound include methylmethoxysiloxane oligomer, methylphenylmethoxysiloxane oligomer, methylepoxymethoxysiloxane oligomer, methylmercaptomethoxysiloxane oligomer, and methylacryloylmethoxysiloxane oligomer.

The alkoxysiloxane compounds may be used singly or in combination of two or more.

Examples of the hydrocarbon solvent used as the compatible substance include aromatic hydrocarbon solvents. Among them, aromatic hydrocarbon solvents are preferable, in view of the compatibility to the polymer composition. Examples of the aromatic hydrocarbon solvents include aromatic hydrocarbon solvents having about 6 to 10 carbon atoms such as toluene, xylene, mesitylene, ethyl benzene, propyl benzene, butyl benzene, and t-butyl benzene, preferably toluene and xylene.

The content of the compatible substance is preferably 10 to 50 parts by mass, more preferably 15 to 40 parts by mass, further preferably 20 to 35 parts by mass, with respect to 100 parts by mass of the polymer composition (when using silicone, the curable silicone composition). When the content of the compatible substance is the aforementioned lower limit or more, the heat-conductive filler is more easily dispersed in the polymer composition. When the content of the compatible substance is the aforementioned upper limit or less, effects according to the amount of the compatible substance used can be obtained.

In step (A), it is preferable to form the oriented molded product from the mixed composition as described above. The mixed composition is preferably cured to form the oriented molded product. More specifically, the oriented molded product can be obtained by the magnetic field orientation production method or the flow orientation production method, of which the magnetic field orientation production method is preferred.

(Magnetic field orientation production method)

In the magnetic field orientation production method, a mixed composition containing a polymer composition, such as a liquid curable silicone composition to serve as a silicone matrix after curing, and a heat-conductive filler containing at least an anisotropic filler, is injected into a mold or the like before being placed in a magnetic field to orient the anisotropic filler along the magnetic field, and then the polymer composition is cured to obtain an oriented molded product. The oriented molded product is preferably in the form of a block.

A release film may be disposed on the portion in contact with the mixed composition in the mold. The release film to be used is, for example, a resin film having good releasability or a resin film having one side treated with a release agent. Use of a release film makes it easy to release the oriented molded product from the mold.

In the magnetic field orientation production method, the viscosity of the mixed composition to be used is preferably 10 to 300 Pa·s in view of orientation of the magnetic field. When it is 10 Pa·s or more, the anisotropic filler or non-anisotropic filler is difficult to settle. When it is 300 Pa·s or less, the mixed composition has an improved fluidity to appropriately orient the anisotropic filler in the magnetic field, and thus the problems, such as the orientation taking too much time, do not arise. The viscosity is measured using a rotational viscometer (Brookfield viscometer DV-E, spindle

SC4-14) at 25°C and a rotational speed of 10 rpm.

In the case of using the anisotropic filler or non-anisotropic filler difficult to settle or combining with an additive such as an anti-settling agent, the viscosity of the mixed composition may be less than 10 Pa·s.

For the magnetic field orientation production method, a superconducting magnet, a permanent magnet, an electromagnet, or the like can be mentioned as a magnetic force line source for applying the magnetic force lines. A superconducting magnet is preferable in view of generating a magnetic field with high magnetic flux density. The magnetic flux density of the magnetic field generated from such a magnetic force line source is preferably 1 to 30 tesla. When the magnetic flux density is 1 tesla or more, the anisotropic filler made of carbon materials or the like can be easily oriented. When it is 30 tesla or less, practical production is enabled.

The curing of the polymer composition such as a curable silicone composition may be performed by heating, and may be, for example, performed at a temperature of about 50 to 150°C. The heating time is, for example, about 10 minutes to 3 hours.

(Flow orientation production method)

In the flow orientation production method, a shear force is applied to the mixed composition to produce a preliminary sheet in which the anisotropic filler is oriented in the plane direction, and a plurality of these sheets is then layered to produce a laminate block, which may be used as the oriented molded product.

More specifically, in the flow orientation production method, a mixed composition containing at least a polymer composition and a heat-conductive filler containing at least an anisotropic filler is first prepared as described above. Here, the polymer compound used in the polymer composition may include a liquid polymer compound at normal temperature (23°C) or may include a solid polymer compound at normal temperature.

The mixed composition has a relatively high viscosity so that a shear force is applied when the composition is stretched into a sheet, and specifically, the viscosity of the mixed composition is preferably 3 to 50 Pa·s. The mixed composition preferably contains a solvent to obtain the above viscosity.

Next, the mixed composition is flattened and stretched while applying a shear force to form a sheet (preliminary sheet). The anisotropic filler can be oriented in the shearing direction by applying a shear force. For forming the sheet, the mixed composition may be applied onto a base film, for example, using a coating applicator such as a bar coater and a doctor blade, or by extrusion molding or discharging from a nozzle, and then the applied mixed composition may be dried or semi-cured, as required. The thickness of the preliminary sheet is preferably about 50 to 250 μm. In the preliminary sheet, the anisotropic filler is oriented in one direction along the plane direction of the sheet.

Then, a laminate block may be formed by layering a plurality of preliminary sheets so that the orientation directions coincide, and bonding the preliminary sheets to each other by hot press or the like while optionally curing the mixed composition by heating, ultraviolet irradiation, or the like, and this laminate block may then be used as an oriented molded product.

Next, the oriented molded product obtained above may be cut by slicing or the like in a direction perpendicular to the direction in which the anisotropic filler is oriented, to obtain a sheet-form molded product. Slicing may be performed, for example, with a shearing blade or a laser.

<Step (B)>

In step (B), the molded product such as the sheet-form molded product obtained in step (A) is polished. The molded product is usually a sheet-form molded product as described above, and the sheet-form molded product may be polished on one or both sides.

The surface may be polished using polishing paper, polishing film, polishing cloth, or polishing belt, for example. In the present production method, the reflectance of the surface in contact with the heat-dissipating element or heating element can be 0.30% or more by polishing the surface of the sheet-form molded product.

As for the properties of the polishing paper, the average particle size (D50) of the abrasive grains contained is preferably 0.1 to 100 μm, more preferably 9 to 60 μm. Using polishing paper with an average particle size of 0.1 μm or more allows to have a reflectance of 0.30% or more for the sheet surface. Using polishing paper with an average particle size of 100 μm or less prevents the surface of the heat-conductive sheet from being scratched, which would be a practical problem. Further, for the same reasons as above, for example, the grit number of the abrasive grains of the polishing paper is preferably #120 to 20000, preferably #300 to 15000, more preferably #320 to 6000.

The polishing method used includes methods such as polishing by continuously abutting polishing paper against the surface of the heat-conductive sheet in the same straight line, as well as by reciprocating a certain distance, rotating in the same direction, or abutting in various directions.

The degree of polishing may be determined while observing the condition of the surface, for example, but in the case of reciprocating polishing, 10 to 500 reciprocations are preferred, 30 to 300 reciprocations are more preferred, and 55

to 150 reciprocations are further preferred. Specifically, it is preferable to polish until the reflectance of the surface of the heat-conductive sheet becomes 0.30% or more.

The polishing of the surface of the heat-conductive sheet is preferably performed in two polishing steps. In this case, the average particle size of the polishing paper used in the first polishing step is preferably 3 to 40 μm larger, more preferably 5 to 30 μm larger, further preferably 10 to 25 μm larger than the average particle size of the polishing paper used in the second polishing step.

Further, the grit number of the polishing paper is preferably different between the first polishing step and the second polishing step. The grit number of the polishing paper in the first polishing step is preferably larger than the grit number of the polishing paper in the second polishing step. The grit number of the polishing paper in the first polishing step is preferably #500 to 8000 greater, more preferably #800 to 5000 greater, further preferably #1000 to 3500 greater than the grit number of the polishing paper in the second polishing step.

Further, the number of times of polishing in the first polishing step is preferably 3 to 120 times greater, more preferably 5 to 100 times greater, further preferably 8 to 80 times greater than the number of times of polishing in the second polishing step.

When divided into two polishing steps as described above, coarse polishing is performed in the first step and fine polishing is performed in the second step, which makes it easier to achieve a surface reflectance of 0.30% or more.

[Usage of heat-conductive sheet]

The heat-conductive sheet of the present invention is used inside an electronic device or the like. Specifically, the heat-conductive sheet is interposed between a heating element and a heat-dissipating element, and is used to conduct heat from the heating element to the heat-dissipating element. Specifically, the heat-conductive sheet is interposed between a heating element and a heat-dissipating element, to move heat generated in the heating element to the heat-dissipating element by heat conduction and dissipate the heat from the heat-dissipating element. Here, examples of the heating element include various electronic parts used inside electronic devices such as CPUs, power semiconductors, and power sources. Examples of the heat-dissipating element include heat sinks, heat pumps, and metal housings of electronic devices. The heat-conductive sheet may be compressed with its two surfaces in close contact with the heating element and the heat-dissipating element, respectively, when use.

## Examples

Hereinafter, the present invention will be described in more detail by way of examples, but the present invention is not limited at all to these examples.

[Properties]

Each property of thermal conductivity was measured by the following methods.

<Reflectance>

The following measuring device was used to measure the reflectance in accordance with the following measurement conditions.

Measuring device: "UV-1900i" available from SHIMADZU CORPORATION
Measurement conditions: the specular reflection of the test pieces prepared in each of Examples and Comparative Examples was measured at a light source of 550 nm, an angle of incidence of 5 degrees, and assuming the reflectance of a standard mirror (silver-coated copper plate) as 100%.

<E hardness>

The heat-conductive sheet obtained in each of Examples and Comparative Examples was layered until the test piece was 10 mm thick and used as a measurement sample. The E hardness of the measurement sample was measured using a Type E durometer in accordance with the Japanese Industrial Standard, JIS K 6253.

<Heat resistance value>

The heat resistance value was measured using a heat resistance value measuring machine as shown in Fig. 1 by the method shown below.

Specifically, a test piece S for this test with a size of 30 mm × 30 mm and a thickness of 1 mm was prepared from each sample. Then, the test piece S was attached onto a copper block 22 having a surface for measurement of 25.4 mm × 25.4 mm and lateral surfaces covered with a heat insulator 21, and sandwiched with an upper copper block 23, and a load was applied thereto by a load cell 26 to set the thickness to 90% of the original thickness. Here, the lower copper block 22 was in contact with a heater 24. The upper copper block 23 was covered by the heat insulator 21 and connected to a heat sink 25 with fan. Then, the heater 24 was allowed to produce heat with a calorific value of 25 W, and 10 minutes later, in which the temperature became substantially steady, the temperature of the upper copper block 23 ($\theta_{j0}$), the temperature of the lower copper block 22 ($\theta_{j1}$), and the calorific value (Q) of the heater were measured, to determine the heat resistance value of the sample from formula (1) below.

$$\text{Heat resistance value} = (\theta_{j1} - \theta_{j0})/Q \cdots \text{formula (1)}$$

In formula (1), $\theta_{j1}$ represents the temperature of the lower copper block 22, $\theta_{j0}$ represents the temperature of the upper copper block 23, and Q represents the calorific value.

<Adhesive strength>

The adhesive strength (tensile shear strength) was measured in accordance with the tensile shear test of JIS K6850:1999.

The heat-conductive sheet prepared by the method of each of Examples and Comparative Examples (20 mm long, 20 mm wide, 0.2 mm thick) was sandwiched between two aluminum sheets (30 mm long, 100 mm wide, 0.012 mm thick). Here, the aluminum sheets were disposed with their tips overlapping each other over a length of 25 mm × 25 mm. They were then crimped for 3 minutes at a temperature of 80°C and a pressure of 20 psi to prepare a test sample. The test sample was cooled naturally to 25°C, and a tensile test was performed using a tensile tester (available from Toyo Seiki Seisaku-sho) at a room temperature of 25°C and a tensile speed of 500 mm/min to measure adhesive strength (tensile shear strength).

<Surface roughness (arithmetic mean height Sa)>

In Examples 1, 5, 9, and Comparative Example 7, the surface roughness (arithmetic mean height Sa) was measured by the following method to evaluate the effects of surface roughness.

Surface property analysis was performed on the heat-conductive sheet of each of Examples and Comparative Examples using a laser microscope (VK-X150 available from KEYENCE CORPORATION) in accordance with ISO 25178. Specifically, the surface profile of a two-dimensional area with a surface area of 1000 μm × 1000 μm was measured by a laser method at a lens magnification of 10×. The average of the measurements of the same sample at three different locations was used as the arithmetic mean height (Sa).

[Example 1]

First, the following materials (1) to (5) were mixed according to the formulations described in Table 1 to obtain mixed compositions. When obtaining the mixed composition, component (3) was dissolved in component (2) before being mixed with the other components.

(1) Curable silicone composition: alkenyl group-containing organopolysiloxane and hydrogen organopolysiloxane (100 parts by mass in total)
(2) Compatible substance: 32 parts by mass of n-decyltrimethoxysilane
(3) Phase change material 1: 18 parts by mass of polyoctadecylmethylsiloxane (melting point: 50°C)
(4) Anisotropic filler: 187 parts by mass of carbon fiber 1 (graphitized carbon fiber with an average fiber length of 100 μm, aspect ratio of 10, and thermal conductivity in the fiber axis direction of 500 W/m·K), 12 parts by mass of carbon fiber 2 (graphitized carbon fiber with an average fiber length of 150 μm, aspect ratio of 15, and thermal conductivity in the fiber axis direction of 500 W/m·K), and 23 parts by mass of flaky graphite powder (average particle size: 130 μm, aspect ratio: 10, thermal conductivity: 550 W/m·K)
(5) Non-anisotropic filler: 35 parts by mass of alumina (spherical, average particle size: 3 μm, aspect ratio: 1.0) and 285 parts by mass of aluminum powder (amorphous, average particle size: 3 μm)

Subsequently, the mixed composition was injected into a mold set so as to have a sufficiently larger thickness than the heat-conductive sheet, and an 8T magnetic field was applied in the thickness direction to orient the carbon fibers in

the thickness direction. Thereafter, the matrix was cured by heating at 80°C for 60 minutes, to obtain an oriented molded product in the form of a block.

Then, using a shearing blade, the oriented molded product in the form of a block was sliced into sheets of 1 mm and 0.2 mm thickness, to obtain a sheet-form molded product.

Subsequently, both surfaces of the sheet-form molded product were polished by reciprocating 25 times with coarse polishing paper A (grit number: #800), in which the average particle size (D50) of the abrasive grains is 20 μm, then further polished by reciprocating 10 times with coarse polishing paper B (grit number: #4000), in which the average particle size (D50) of the abrasive grains is 3 μm, and then heated at 150°C for 2 hours to obtain a heat-conductive sheet.

[Examples 2 to 5]

The heat-conductive sheet was obtained in the same manner as in Example 1 except that the formulation of the mixed composition was changed as shown in Table 1.

The phase change material 2 is as follows.

Phase change material 2: side-chain crystalline polyalphaolefin (CPAO, melting point: 42°C)

[Table 1]

| | | Example 1 | Example 2 | Example 3 | Example 4 | Example 5 |
|---|---|---|---|---|---|---|
| Formulation (parts by mass) | Curable silicone composition | 100 | 100 | 100 | 100 | 100 |
| | n-Decyltrimethoxysilane | 32 | 34 | 30 | 28 | 30 |
| | Phase change material 1 | 18 | 25 | | 3 | 11 |
| | Phase change material 2 | | | 11 | | |
| | Graphitized carbon fiber 1 | 187 | 199 | 177 | 164 | 177 |
| | Graphitized carbon fiber 2 | 12 | 12 | 11 | 10 | 11 |
| | Flaky graphite powder | 23 | 25 | 22 | 21 | 22 |
| | Alumina | 35 | 37 | 33 | 31 | 33 |
| | Aluminum | 285 | 303 | 269 | 250 | 269 |
| Properties | Reflectance (%) | 0.50 | 0.56 | 0.52 | 0.37 | 0.42 |
| | E hardness | 65 | 71 | 58 | 49 | 62 |
| | Heat resistance value(°C/W) @40 psi | 0.106 | 0.104 | 0.105 | 0.128 | 0.125 |
| | Adhesive strength (MPa) | 1.31 | 1.34 | 1.11 | 0.15 | 1.24 |
| Number of polishing times | 20 μm (# 800) | 25 | 25 | 25 | 25 | 25 |
| | 3 μm (# 4000) | 10 | 10 | 10 | 10 | 10 |

[Examples 6 to 17]

The heat-conductive sheet was obtained in the same manner as in Example 1 except that the formulation of the mixed composition and the number of times of reciprocating polishing was changed as shown in Tables 2 and 3.

[Table 2]

| | | Example 6 | Example 7 | Example 8 | Example 9 | Example 10 | Example 11 |
|---|---|---|---|---|---|---|---|
| Formulation (parts by mass) | Curable silicone composition | 100 | 100 | 100 | 100 | 100 | 100 |
| | n-Decyltrimethoxysilane | 15 | 28 | 30 | 32 | 34 | 30 |
| | Phase change material 1 | | 3 | 11 | 18 | 25 | |
| | Phase change material 2 | | | | | | 11 |
| | Graphitized carbon fiber 1 | 154 | 164 | 177 | 187 | 199 | 177 |
| | Graphitized carbon fiber 2 | 10 | 10 | 11 | 12 | 12 | 11 |
| | Flaky graphite powder | 20 | 21 | 22 | 23 | 25 | 22 |
| | Alumina | | 31 | 33 | 35 | 37 | 33 |
| | Aluminum | 242 | 250 | 269 | 285 | 303 | 269 |
| Properties | Reflectance (%) | 0.37 | 0.68 | 0.89 | 0.64 | 0.89 | 0.58 |
| | E hardness | 47 | 49 | 62 | 65 | 71 | 58 |
| | Heat resistance value (°C/W) @40 psi | 0.117 | 0.100 | 0.101 | 0.100 | 0.098 | 0.103 |
| | Adhesive strength (MPa) | 0.23 | 0.45 | 1.38 | 1.40 | 1.48 | 1.36 |
| Number of polishing times | 20 µm (# 800) | 50 | 50 | 50 | 50 | 50 | 50 |
| | 3 µm (# 4000) | 10 | 10 | 10 | 10 | 10 | 10 |

[Table 3]

| | | Example 12 | Example 13 | Example 14 | Example 15 | Example 16 | Example 17 |
|---|---|---|---|---|---|---|---|
| Formulation (parts by mass) | Curable silicone composition | 100 | 100 | 100 | 100 | 100 | 100 |
| | n-Decyltrimethoxysilane | 15 | 28 | 30 | 32 | 34 | 30 |
| | Phase change material 1 | | 3 | 11 | 18 | 25 | |
| | Phase change material 2 | | | | | | 11 |
| | Graphitized carbon fiber 1 | 154 | 164 | 177 | 187 | 199 | 177 |
| | Graphitized carbon fiber 2 | 10 | 10 | 11 | 12 | 12 | 11 |
| | Flaky graphite powder | 20 | 21 | 22 | 23 | 25 | 22 |
| | Alumina | | 31 | 33 | 35 | 37 | 33 |
| | Aluminum | 242 | 250 | 269 | 285 | 303 | 269 |
| Properties | Reflectance (%) | 0.40 | 0.79 | 1.02 | 0.75 | 1.02 | 0.77 |
| | E hardness | 47 | 49 | 62 | 65 | 71 | 58 |
| | Heat resistance value (°C/W) @40 psi | 0.111 | 0.094 | 0.099 | 0.094 | 0.092 | 0.096 |
| | Adhesive strength (MPa) | 0.39 | 0.50 | 1.90 | 2.10 | 2.20 | 1.91 |
| Number of polishing times | 20 µm (# 800) | 75 | 75 | 75 | 75 | 75 | 75 |
| | 3 µm (# 4000) | 10 | 10 | 10 | 10 | 10 | 10 |

[Comparative Examples 1 to 7]

The heat-conductive sheet was obtained in the same manner as in Example 1 except that the formulation of the mixed composition and the number of times of reciprocating polishing was changed as shown in Table 4.

[Table 4]

| | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|
| Formulation (parts by mass) | Curable silicone composition | 100 | 100 | 100 | 100 | 100 | 100 | 100 |
| | n-Decyltrimethoxysilane | 15 | 28 | 30 | 32 | 34 | 30 | 15 |
| | Phase change material 1 | | 3 | 11 | 18 | 25 | | |
| | Phase change material 2 | | | | | | 11 | |
| | Graphitized carbon fiber 1 | 154 | 164 | 177 | 187 | 199 | 177 | 154 |
| | Graphitized carbon fiber 2 | 10 | 10 | 11 | 12 | 12 | 11 | 10 |
| | Flaky graphite powder | 20 | 21 | 22 | 23 | 25 | 22 | 20 |
| | Alumina | | 31 | 33 | 35 | 37 | 33 | |
| | Aluminum | 242 | 250 | 269 | 285 | 303 | 269 | 242 |
| Properties | Reflectance (%) | 0.18 | 0.16 | 0.18 | 0.18 | 0.19 | 0.18 | 0.28 |
| | E hardness | 47 | 49 | 62 | 65 | 71 | 58 | 47 |
| | Heat resistance value (°C/W) (@40 psi | 0.250 | 0.238 | 0.217 | 0.191 | 0.196 | 0.196 | 0.133 |
| | Adhesive strength (MPa) | 0 | 0 | 0 | 0 | 0 | 0 | 0 |
| Number of polishing times | 20 μm (# 800) | 0 | 0 | 0 | 0 | 0 | 0 | 25 |
| | 3 μm (# 4000) | 0 | 0 | 0 | 0 | 0 | 0 | 10 |

As evident from the above Examples, the heat-conductive sheets that satisfied the requirements of the present invention had good thermal conductivity due to their high adhesive strength to the heating element and the heat-dissipating element, and to their low heat resistance value. Further, the improvement in adhesive strength was particularly noticeable on the polished surfaces of those containing a phase change material.

In contrast, the heat-conductive sheets prepared in Comparative Examples did not have the above adhesive strength and had high heat resistance value, and therefore good thermal conductivity could not be obtained.

The results of the measurement and discussion of the surface roughness (arithmetic mean height Sa) are as follows.

The surface roughness was 6.9 μm in Example 1, 5.5 μm in Example 5, 5.6 μm in Example 9, and 10.1 μm in Comparative Example 7.

Here, when comparing Example 1 with Comparative Example 7, it can be seen that Sa is smaller and the heat resistance value is smaller as well, but when comparing Example 1 with Examples 5 and 9, it was found that a smaller Sa does not necessarily mean a smaller heat resistance value. Further, in the comparison between Example 5 and Example 9, despite a similar Sa, the heat resistance value was 0.125°C/W in Example 5 and 0.100°C/W in Example 9, which is a difference of 0.025°C/W.

On the other hand, a correlation between the reflectance and heat resistance value was observed for the heat-conductive sheets prepared in Examples 1, 5, 9, and Comparative Example 7.

From the above, it was found that in areas where heat resistance value is extremely small, reducing the surface roughness did not necessarily result in a lower heat resistance value.

Reference Signs List

21: Heat insulator
22: Lower copper block
23: Upper copper block
24: Heater
25: Heat sink
26: Load cell
S: Test piece
$\theta_{j0}$: Temperature of upper copper block
$\theta_{j1}$: Temperature of lower copper block

**Claims**

1. A heat-conductive sheet comprising a binder and a heat-conductive filler dispersed in the binder, that is used in a state of being sandwiched between a heating element and a heat-dissipating element,
   the heat-conductive sheet having a reflectance of 0.30% or more at a surface in contact with the heating element or the heat-dissipating element.

2. The heat-conductive sheet according to claim 1, wherein the heat-conductive sheet has no fluidity in 0 to 100°C.

3. The heat-conductive sheet according to claim 1 or 2, wherein the heat-conductive filler comprises an anisotropic filler oriented in a thickness direction of the heat-conductive sheet.

4. The heat-conductive sheet according to any one of claims 1 to 3, wherein the heat-conductive filler comprises a graphite material.

5. The heat-conductive sheet according to any one of claims 1 to 4, wherein the reflectance is 0.45% or more.

6. The heat-conductive sheet according to any one of claims 1 to 5, wherein the binder comprises a crosslinked silicone.

7. The heat-conductive sheet according to any one of claims 1 to 6, comprising a phase change material.

8. The heat-conductive sheet according to claim 7, wherein a content of the phase change material is 2 to 30 parts by mass per 100 parts by mass of the binder.

9. The heat-conductive sheet according to claim 7 or 8, wherein the phase change material is an alkyl silicone.

10. The heat-conductive sheet according to any one of claims 1 to 9, wherein the surface with the reflectance of 0.30% or more is a sliced surface.

11. The heat-conductive sheet according to any one of claims 1 to 10, wherein an E hardness of the heat-conductive sheet is 10 to 80.

12. A method for producing the heat-conductive sheet according to any one of claims 1 to 11, comprising polishing a surface of a molded product comprising a binder and a heat-conductive filler dispersed in the binder.

Fig. 1

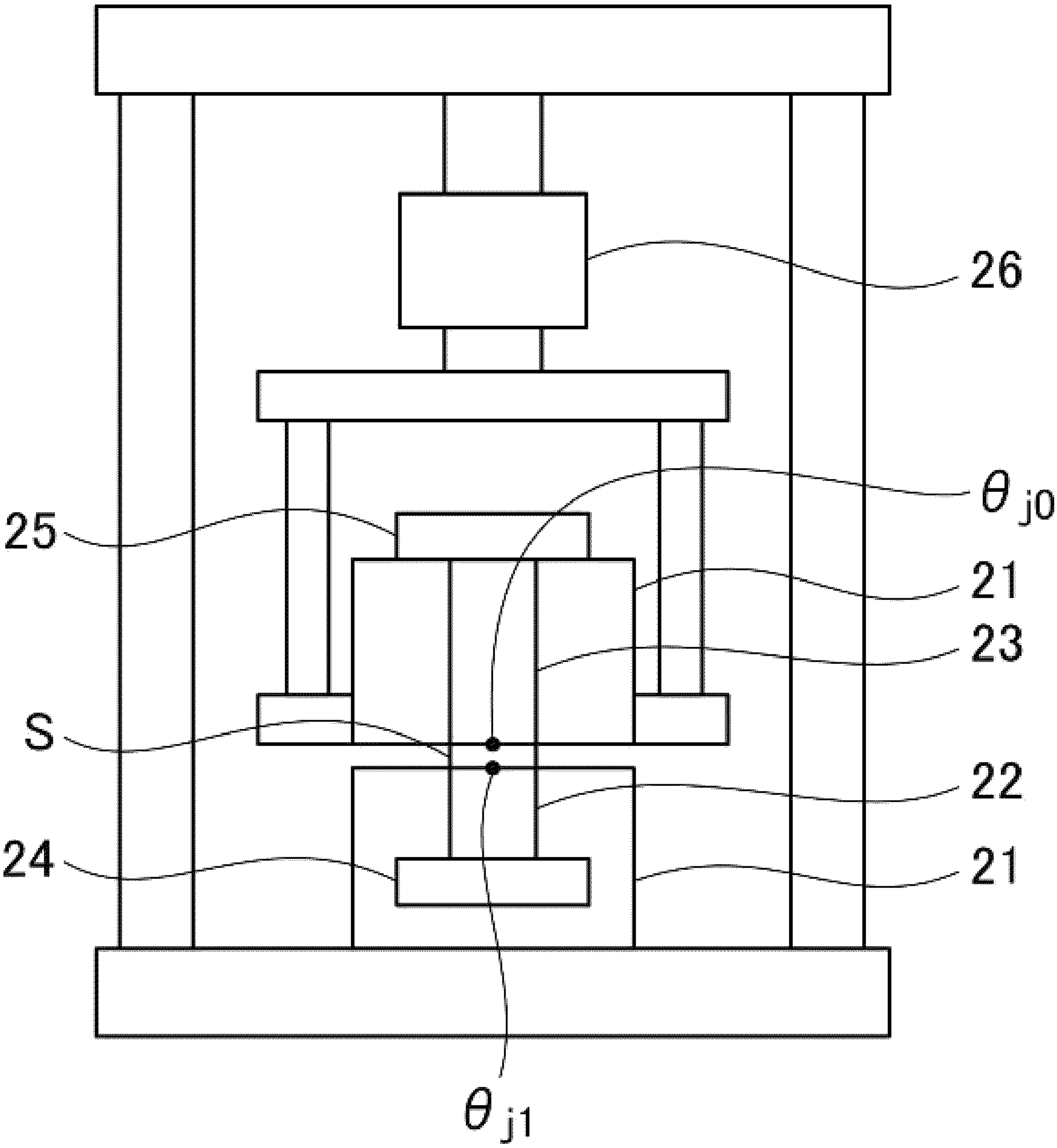

**INTERNATIONAL SEARCH REPORT**

International application No. **PCT/JP2023/012650**

**A. CLASSIFICATION OF SUBJECT MATTER**

***H01L 23/373***(2006.01)i; ***H01L 23/36***(2006.01)i; ***H05K 7/20***(2006.01)i
FI: H01L23/36 M; H01L23/36 D; H05K7/20 F

According to International Patent Classification (IPC) or to both national classification and IPC

**B. FIELDS SEARCHED**

Minimum documentation searched (classification system followed by classification symbols)

H01L23/373; H01L23/36; H05K7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-39067 A (NITTO DENKO CORP.) 23 February 2012 (2012-02-23) paragraphs [0013]-[0178] | 1-2, 5-6 |
| A | | 3-4, 7-12 |
| A | JP 2004-331835 A (FUJI POLYMER INDUSTRIES CO., LTD.) 25 November 2004 (2004-11-25) entire text | 1-12 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 May 2023** | **23 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/012650**

| Patent document cited in search report | Publication date (day/month/year) | Patent family member(s) | Publication date (day/month/year) |
|---|---|---|---|
| JP 2012-39067 A | 23 February 2012 | US 2011/0259566 A1<br>paragraphs [0030]-[0244]<br>CN 102140257 A<br>KR 10-2011-0089097 A<br>TW 201137010 A | |
| JP 2004-331835 A | 25 November 2004 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004331835 A
- JP 2010185052 A